# EUROPEAN PATENT APPLICATION

(11) **EP 0 782 199 A2**
(43) Date of publication of application: **02.07.1997**
(21) Application number: 96120260.3
(22) Date of filing: 17.12.1996
(51) Int. Cl.: H01L 29/74, H01L 21/332

(54) **High voltage semiconductor device and method for manufacturing the same**

(30) Priority: 27.12.1995 JP 341190/95
(71) Applicant: KABUSHIKI KAISHA TOSHIBA, Kawasaki-shi (JP)
(72) Inventor: Tsuchitani, Masanobu, 1-1 Shibaura 1-chome Minato-ku Tokyo 105 (JP); Baba, Yoshiro, 1-1 Shibaura 1-chome Minato-ku Tokyo 105 (JP); Hoshi, Tadahide, 1-1 Shibaura 1-chome Minato-ku Tokyo 105 (JP)
(74) Representative: Zangs, Rainer E., Dipl.-Ing.

(57) **Abstract**

A semiconductor device of high withstand voltage such as a thyristor has a p-type region (4) formed on one surface of an n-type semiconductor substrate (33) used as a base. An n-type region (5) used as a cathode layer is formed in the p-type region (4). A p-type epitaxial growth layer (31) used as an anode layer is formed on the opposite surface of the n-type semiconductor substrate (33).

## Description

This invention relates to a semiconductor device of high withstand voltage such as a thyristor and a method for manufacturing the same.

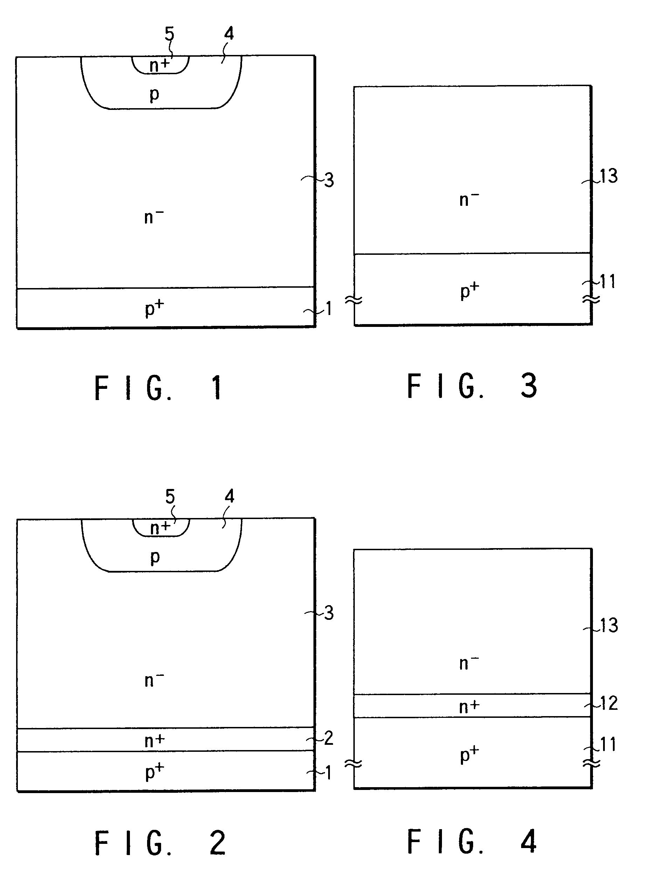

A thyristor is one of high-withstand voltage semiconductor devices such as power semiconductor devices and, for example, it is constructed by a p-type semiconductor layer 1 formed in a semiconductor substrate, an n-type semiconductor layer 3, a p-type semiconductor region 4 and an n-type semiconductor region 5 as shown in FIG. 1. The p-type semiconductor layer 1 is used as an anode layer, the n-type semiconductor region 5 is used as a cathode layer, the n-type semiconductor layer 3 is used as an n-type base layer, and the p-type semiconductor region 4 is used as a p-type base layer.

Further, as shown in FIG. 2, it is known to enhance the performance of the thyristor by forming an n-type semiconductor layer 2 between the p-type semiconductor layer 1 and the n-type semiconductor layer 3. The impurity concentration of the n-type semiconductor layer 3 is lower than that of the n-type semiconductor layer 2. That is, since hole injection from the p-type semiconductor layer 1 into the n-type semiconductor layer 3 is suppressed by the presence of the n-type semiconductor layer 2, the turn-OFF current of the thyristor can be suppressed and the switching speed thereof can be enhanced.

Further, when the thyristor is turned OFF, a depletion layer is formed to extend from the junction plane between the p-type semiconductor layer 4 and the n-type semiconductor layer 3 into the n-type semiconductor layer 3, but extension of the depletion layer can be suppressed by the presence of the n-type semiconductor layer 2. Therefore, the depletion layer can be prevented from being set in contact with the p-type semiconductor layer 1 and the withstand voltage of the element can be enhanced. The n-type semiconductor layer 2 is generally called a buffer layer.

Conventionally, in order to form the above thyristor, a semiconductor substrate having a pn junction formed by the epitaxial growth method or diffusion method is used.

A method for forming a semiconductor substrate having a pn junction formed by use of the epitaxial growth method is shown in FIG. 3. An n⁻ layer is formed on a p-type semiconductor substrate 11 of high impurity concentration by growing an n-type semiconductor layer 13 by use of the epitaxial growth method.

In a method shown in FIG. 4, an n-type semiconductor layer 12 of high impurity concentration is formed on a p-type semiconductor layer 11 of high impurity concentration by use of the epitaxial growth method, and an n-type semiconductor layer 13 of low impurity concentration is formed on the n-type semiconductor layer 12 by use of the epitaxial growth method to form an n⁺ layer and n⁻ layer.

However, generally, in the epitaxial growth technology, if the thickness of the epitaxial growth layer becomes approx. 150 µm or more, for example, the crystallinity of the epitaxial growth layer is degraded. Therefore, if a semiconductor device is manufactured by use of such a semiconductor substrate, the manufacturing yield is lowered.

Therefore, in a case where an n⁻ layer is formed by use of the epitaxial growth method, the thickness of the n⁻ layer cannot be limitlessly increased.

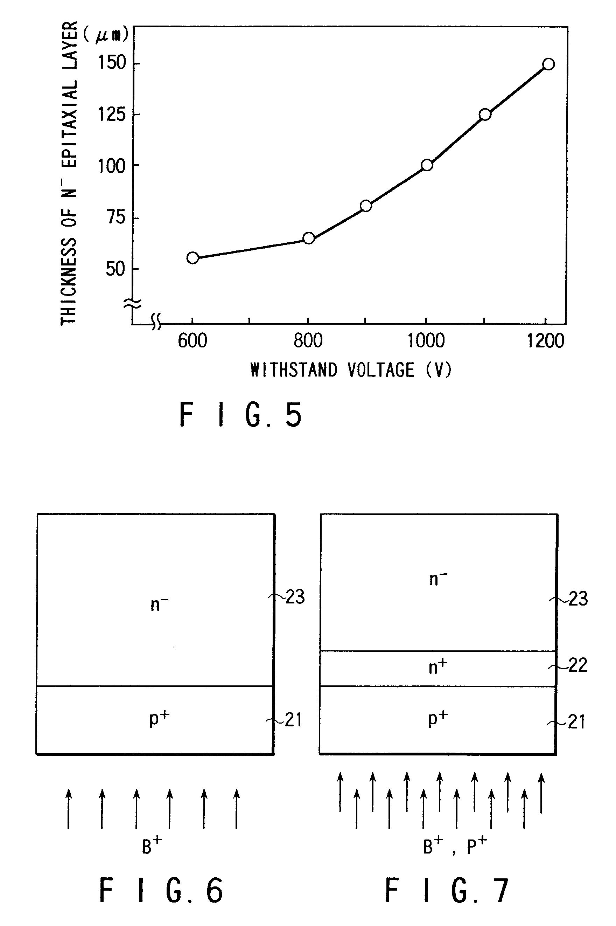

The relation between the withstand voltage of a thyristor and the thickness of the n-type of base layer of the n⁻ layer is shown in FIG. 5. As shown in FIG. 5, generally, in order to enhance the withstand voltage of the thyristor, it is necessary to increase the thickness of the n⁻ layer. However, if the conventional method in which the thickness of the n⁻layer has a limitation is used, there occurs a problem that the withstand voltage cannot be set higher than a certain critical value.

As a semiconductor substrate forming method for solving the above problem, a method using the diffusion method is provided as shown in FIG. 6. A p-type diffusion layer 21 is formed by diffusing, for example, boron B⁺ of high concentration into an n-type semiconductor substrate 23 from one surface thereof by the diffusion method.

The p-type diffusion layer 21 is used as the anode layer of the device shown in FIG. 4 and the n-type semiconductor substrate 23 is used as the n-type base layer.

In the method shown in FIG. 7, an n-type diffusion layer 22 is formed by diffusing, for example, phosphorus P⁺ of high concentration from one surface of the n-type semiconductor substrate 23, and then a p-type diffusion layer 21 is formed by further diffusing boron B⁺ of high concentration. The n-type diffusion layer 22 is used as the buffer layer, the p-type diffusion layer 21 is used as the anode layer, and the n-type semiconductor substrate 23 is used as the n-type base layer.

With the above method, since the n-type semiconductor substrate 23 is used as the n-type base layer, the base layer can be made sufficiently thick to enhance the withstand voltage.

However, since the p-type diffusion layer used as the anode layer is formed by the diffusion method, the concentration distribution in the junction plane between the p-type diffusion layer 21 and the n-type semiconductor substrate 23 shown in FIG. 6 or the concentration distribution in the junction plane between the p-type diffusion layer 21 and the n-type diffusion layer 22 shown in FIG. 7 becomes smooth. As a result, there occurs a problem that the carrier injection efficiency is lowered and the on-state voltage becomes high.

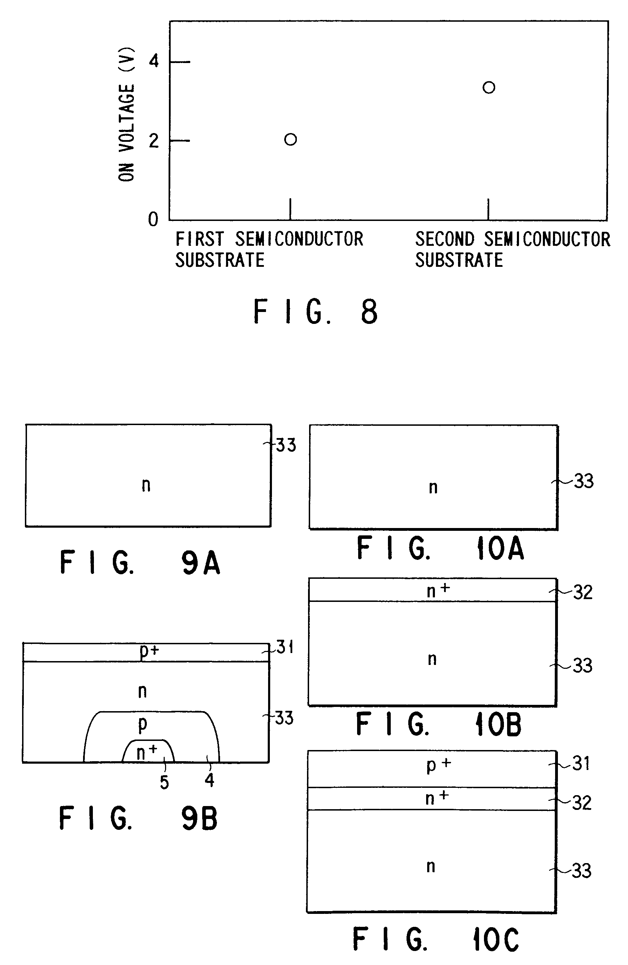

FIG. 8 shows a case wherein the on-state voltages of thyristors formed of semiconductor substrates respectively formed by the first method shown in FIGS. 3 and 4 and the second method shown in FIGS. 6 and 7 are compared.

As is clearly seen from FIG. 8, the on-state voltage obtained when the semiconductor substrate formed by the second method is used is higher by approx. 1V than the on-state voltage obtained when the semiconductor substrate formed by the first method is used.

Thus, in the conventional semiconductor device and the manufacturing method thereof, since the n-type base layer cannot be made sufficiently thick when the n-type semiconductor layer is formed on the p-type semiconductor substrate by the epitaxial growth method and the n-type semiconductor layer is used as the n-type base layer, it is difficult to realize a thyristor of high withstand voltage.

Further, since the concentration distribution in the junction plane between the n-type semiconductor substrate and the p-type diffusion layer becomes smooth when the p-type diffusion layer is formed on the n-type semiconductor substrate by the diffusion method and the p-type diffusion layer is used as the anode layer, there occurs a problem that the carrier injection efficiency is lowered and the on-state voltage becomes high.

An object of this invention is to provide a semiconductor device capable of solving the above conventional problem and permitting a thyristor having a high withstand voltage and low on-state voltage to be easily realized at low cost and a method for manufacturing the same.

In order to attain the above object, a semiconductor device of this invention comprises an n-type semiconductor substrate used as a base; a p-type region formed on one surface of the n-type semiconductor substrate; an n-type region formed in the p-type region and used as a cathode layer; and a p-type epitaxial growth layer formed on the opposite surface of the n-type semiconductor substrate and used as an anode layer.

Further, a semiconductor device of this invention comprises an n-type semiconductor substrate used as a base; a p-type region formed on one surface of the n-type semiconductor substrate; an n-type region formed in the p-type region and used as a cathode layer; a first epitaxial growth layer of n type with high impurity concentration formed on the opposite surface of the n-type semiconductor substrate; and a second epitaxial growth layer of p type formed on the first epitaxial growth layer of n type and used as an anode layer.

Further, a method for manufacturing a semiconductor device of this invention comprises the steps of forming a p-type region on one surface of an n-type semiconductor substrate used as a base; forming an n-type region used as a cathode layer in the p-type region; and forming a p-type epitaxial growth layer used as an anode layer on the opposite surface of the semiconductor substrate.

Further, a method for manufacturing a semiconductor device of this invention comprises the steps of forming a first epitaxial growth layer of n type on one surface of an n-type semiconductor substrate; and forming a second epitaxial growth layer of p type used as an anode layer on the first epitaxial growth layer.

With the above structure, in the semiconductor device of this invention, since the base layer can be made sufficiently thick by constructing the base layer by the n-type semiconductor substrate irrespective of whether the semiconductor device is of non-punch type or punch type, the withstand voltage of the semiconductor device can be enhanced.

In a case where the first epitaxial growth layer of n type is formed on the n-type semiconductor substrate and the second epitaxial growth layer is formed as the anode layer on the first epitaxial growth layer, the concentration distribution in the junction plane between the anode layer and the first epitaxial layer can be made sharp.

As a result, since the efficiency of injection of holes from the anode layer into the base layer can be enhanced, the on-state voltage of the semiconductor device can be lowered.

Further, in the method for manufacturing the semiconductor device according to this invention, since the n-type semiconductor layer and p-type semiconductor layer are formed on the n-type semiconductor substrate by use of the epitaxial growth method, the concentration distribution in the junction plane between the n-type semiconductor layer and p-type semiconductor layer can be made sharp.

That is, since the p-type semiconductor layer is formed as the anode layer and the concentration distribution in the junction plane between the anode layer and the base layer can be made sharp, the injection efficiency of holes from the anode layer into the base layer can be enhanced so that the on-state voltage of the semiconductor device can be lowered.

Further, since the n-type semiconductor substrate is used as the n-type base layer, the n-type base layer can be made thick, thereby making it possible to enhance the withstand voltage of the semiconductor device.

Further, since the thickness required for the semiconductor layer to be used as the anode layer is smaller than the thickness required for the semiconductor layer to be used as the base layer, the thickness of the epitaxial growth layer can be made small. Therefore, the quality of the epitaxial growth layer can be enhanced and the manufacturing cost can be lowered.

This invention can be more fully understood from the following detailed description when taken in conjunction with the accompanying drawings, in which:
FIG. 1 is a cross sectional view showing an example of the structure of the conventional thyristor;
FIG. 2 is a cross sectional view showing another example of the structure of the conventional thyristor;
FIG. 3 is a cross sectional view for illustrating one step of an example of the manufacturing method of a thyristor by use of the conventional epitaxial growth method;
FIG. 4 is a cross sectional view for illustrating one step of another example of the manufacturing method of a thyristor by use of the conventional epitaxial growth method;
FIG. 5 is a diagram showing the relation between the element withstand voltage and the thickness of the epitaxial growth layer in the structure of the conventional thyristor;
FIG. 6 is a cross sectional view for illustrating one step of an example of the manufacturing method of a thyristor by use of the conventional diffusion method;
FIG. 7 is a cross sectional view for illustrating one step of another example of the manufacturing method of a thyristor by use of the conventional diffusion method;
FIG. 8 is a diagram showing the on-state voltages thyristors formed by the conventional epitaxial growth and the conventional diffusion method for comparison;
FIGS. 9A and 9B are cross sectional views for illustrating the steps of first embodiment of the manufacturing method of a thyristor according to this invention;
FIGS. 10A to 10C are cross sectional views for illustrating the steps of second embodiment of the manufacturing method of a thyristor according to this invention;
FIGS. 11A to 11C are cross sectional views for illustrating the steps of third embodiment of the manufacturing method of a thyristor according to this invention; and
FIGS. 12A to 12C are cross sectional views for illustrating the steps of fourth embodiment of the manufacturing method of a thyristor according to this invention.

There will now be described an embodiment of this invention with reference to the accompanying drawings.

FIGS. 9A and 9B are cross sectional views for illustrating the steps of first embodiment of the manufacturing method of a thyristor according to this invention.

A p-type semiconductor layer 31 with impurity concentration of approx. 1 × 10¹⁹ cm⁻³ and a thickness of approx. 15 µm, for example, is formed on the n-type semiconductor substrate 33 by the epitaxial growth method (FIGS. 9A and 9B).

After this, a p-type diffusion region 4 and an n-type diffusion region 5 are formed on the opposite surface of the n-type semiconductor substrate 33 by a normal process to complete a thyristor of pnpn structure, for example. In this case, the p-type semiconductor layer 31 formed by the epitaxial growth method is used as the anode layer and the semiconductor substrate 33 is used as the base layer.

Thus, the thyristor according to one embodiment of this invention is characterized in that the p-type semiconductor layer 31 which is used as the anode layer is formed by use of the epitaxial growth method.

The thickness of the p-type semiconductor layer 31 is sufficient if it is several ten µm or more. On the other hand, in order to enhance the withstand voltage, it is preferable to set the base layer 33 which is an n⁻ layer thicker and, for example, if it is required to attain the withstand voltage of 1200V, the thickness must be set to 150 µm or more. Thus, since the thickness of the p-type semiconductor layer 31 which is the anode layer is smaller than the thickness of the base layer 33 which is the n⁻ layer, the epitaxial growth layer can be made thinner in the case of this embodiment in which the anode layer is formed by the epitaxial growth method in comparison with the conventional case in which the base layer 33 which is the n⁻ layer is formed by the epitaxial growth method. Therefore, the manufacturing cost can be lowered.

Generally, as the epitaxial growth layer becomes thicker, the crystallinity of the epitaxial growth layer becomes lower, and therefore, the manufacturing yield becomes lower in the case of a semiconductor device using a thick epitaxial growth layer than in the case of a semiconductor device using a thin epitaxial growth layer. In this embodiment, since the epitaxial growth layer can be made thin, the manufacturing yield can be enhanced and the manufacturing cost can be lowered.

Further, as described above, since the thickness of the epitaxial growth layer is limited due to the problem of crystallinity, it is difficult to form a semiconductor device of high withstand voltage by the conventional method in which the n⁻ layer surving as the base layer 33 is formed by the epitaxial growth method.

However, in this embodiment, since the n⁻ layer is formed of the n-type semiconductor substrate, the n⁻layer surving as the base layer 33 can be formed with sufficient thickness and a semiconductor device with high withstand voltage can be attained.

Further, in this embodiment, since the p-type semiconductor layer 31 are formed by use of the epitaxial growth method, the concentration distribution in the junction plane between the base layer 33 and the p-type semiconductor layer 31 can be made sharp. As a result, the injection efficiency of holes from the p-type semiconductor layer 31 into the base layer 33 can be enhanced and the on-state voltage can be lowered.

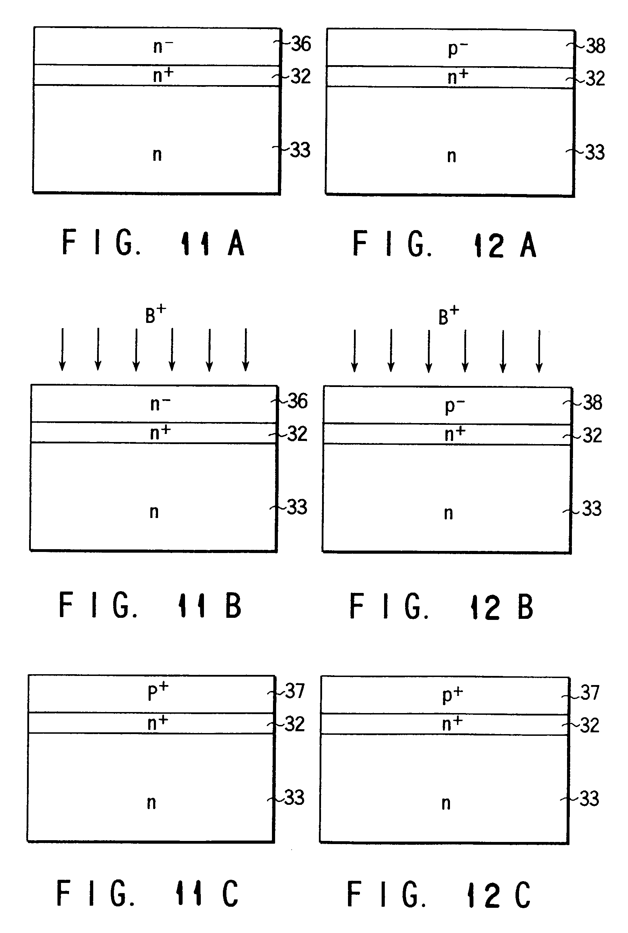

Next, a method for manufacturing a semiconductor device according to the second embodiment of this invention is explained with reference to FIGS. 10A to 10C.

FIGS. 10A to 10C are cross sectional views for illustrating the steps of the second embodiment of the manufacturing method of a thyristory according to this invention and an n-type semiconductor layer 32 with impurity concentration of approx. 1 × 10¹⁸ cm⁻³ and a thickness of approx. 5 µm, for example, is formed on one surface of an n-type semiconductor substrate 33 with impurity concentration of approx. 4 × 10¹³ cm⁻³, for example, (FIG. 10A) by use of the epitaxial growth method (FIG. 10B).

Next , a p-type semiconductor layer 31 with impurity concentration of approx. 1 × 10¹⁹ cm⁻³ and a thickness of approx. 15µm, for example, is formed on the n-type semiconductor layer 32 by the epitaxial growth method (FIG. 10C).

After this, a p-type diffusion region 4 and an n-type diffusion region 5 are formed on the opposite surface of the n-type semiconductor substrate 33 by a normal process to complete a thyristor of pnpn structure, for example, in this case, the p-type semiconductor layer 31 formed by the epitaxial growth method is used as the anode layer, the n-type semiconductor layer 32 is used as the buffer layer, and the semiconductor substrate 33 is used as the based layer.

Further, in order to suppress the injection of holes from the p-type semiconductor layer 31 which is the anode layer and suppress extension of the depletion layer fro the n-type semiconductor substrate 33, it is preferable to set the product of the thickness and the concentration of the semiconductor layer 32 in a range of 10¹⁴ cm⁻² to 10¹⁵ cm⁻².

Further, in order to enhance the injection of holes from the p-type semiconductor layer 31 which is the anode layer into the n-type semiconductor substrate 33 which is the base layer, it is preferable to set the concentration higher than 10¹⁸ cm⁻³ and set the thickness larger than 3 µm.

Thus, the thyristor according to second embodiment of this invention is characterized in that the n-type semiconductor layer 32 and the p-type semiconductor layer 31 which is used as the anode layer and adjacent to the n-type semiconductor layer 32 are formed by use of the epitaxial growth method.

The sum of the thicknesses of the n-type semiconductor layer 32 and the p-type semiconductor layer 31 is sufficient if it is several then µm or more. On the other hand, in order to enhance the withstand voltage, it is preferable to set the base layer 33 which is an n⁻ layer thicker and, for example, if it is required to attain the withstand voltage of 1200V, the thickness must be set to 150 µm or more. Thus, since the thickness of the p-type semiconductor layer 31 which is the anode layer is smaller than the thickness of the base layer 33 which is the n⁻ layer, the epitaxial growth layer can be made thinner in the case of this embodiment in which the anode layer is formed by the epitaxial growth method in comparison with the conventional case in which the base layer 33 which is the n⁻ layer is formed by the epitaxial growth method. Therefore, the manufacturing coast can be lowered.

Generally, as the epitaxial growth layer becomes thicker, the crystallinity of the epitaxial growth layer becomes lower, and therefore, the manufacturing yield becomes lower in the case of a semiconductor device using a thick epitaxial growth layer than in the case of a semiconductor device using a thin epitaxial growth layer. In this embodiment, since the epitaxial growth layer can be made thin, the manufacturing yield can be enhanced and the manufacturing cost can be lowered.

Further, as described above, since the thickness of the epitaxial growth layer is limited due to the problem of crystallinity, it is difficult to form a semiconductor device of high withstand voltage by the conventional method in which the n⁻ layer surving as the base layer 33 is formed by the epitaxial growth method.

However, in this embodiment, since the n⁻ layer is formed of the n-type semiconductor substrate, the n⁻layer surving as the base layer 33 can be formed with sufficient thickness and a semiconductor device with high withstand voltage can be attained.

Further, in this embodiment, since the n-type semiconductor layer 32 and the p-type semiconductor layer 31 are formed by use of the epitaxial growth method, the concentration distribution in the junction plane between the base layer 33 and the p-type semiconductor layer 31 can be made sharp. As a result, the injection efficiency of holes from the p-type semiconductor layer 31 into the base layer 33 can be enhanced and the on-state voltage can be lowered.

Next, a method for manufacturing a semiconductor device according to the third embodiment of this invention is explained with reference to FIGS. 11A to 11C.

Like the second embodiment, in this embodiment, a semiconductor layer which is used as an anode layer is formed on an n-type semiconductor substrate by use of the epitaxial growth method, but unlike the second embodiment in which the anode layer of high impurity concentration is directly formed by use of the epitaxial growth method, in this embodiment, the anode layer is formed by forming an epitaxial growth layer of low concentration and then doping impurity by the diffusion method after the ion-implantation.

First, an n-type semiconductor layer 32 with impurity concentration of approx. 1 × 10¹⁸ cm⁻³ and a thickness of approx. 5 µm, for example, is formed on one surface of an n-type semiconductor substrate 33 with impurity concentration of approx. 4 × 10¹³ cm⁻³, for example, by use of the epitaxial growth method.

Then, the epitaxial growth layer is further grown, but in this case, unlike the second embodiment, an n-type semiconductor layer 36 with impurity concentration of approx. 1 × 10¹⁵ cm⁻³ and a thickness of approx. 15 µm, for example, is formed (FIG. 11A).

Next, boron is ion-implanted into the n-type semiconductor layer 36 from the front surface side thereof by the ion-implantation technique in a condition that the acceleration voltage is 70 keV and the dose amount is 8 × 10¹⁵ cm⁻², for example (FIG. 11B).

Further, the heat treatment is effected for six hours at a temperature of 1200°C, for example, to form a p-type diffusion layer 37 with a depth of 15 µm, for example (FIG. 11C).

After this, a p-type diffusion region 4 and an n-type diffusion region 5 are formed on the opposite surface of the n-type semiconductor layer 36 by a normal process to complete a thyristor of pnpn structure.

Next, third embodiment of this invention is explained with reference to FIGS. 12A to 12C. FIG. 12A shows a case wherein a p-type semiconductor layer 38 is formed instead of the n-type semiconductor layer 36 of FIG. 11A in the former embodiment.

In this example, the p-type semiconductor layer 38 which is an epitaxial growth layer is further formed on the n-type epitaxial growth layer 32 which is formed on the n-type semiconductor substrate 33, but unlike the second embodiment, the p-type semiconductor layer has impurity concentration of approx. 1 × 10¹⁵ cm⁻³ and a thickness of approx. 15 µm, for example. After this, like the case shown in FIG. 11B, boron is ion-implanted (FIG. 12B) and the heat treatment is effected to form a p-type diffusion layer 37 (FIG. 12C).

The other embodiments shown in FIGS. 11C and 12C of this invention are characterized in that after the n-type semiconductor layer 32 which is used as a buffer layer is formed by the epitaxial growth method, an epitaxial growth layer of low concentration is formed and the p-type diffusion layer 37 which is used as the anode layer is formed by the diffusion method.

Like the case of the embodiment shown in FIG. 10C, since the semiconductor layer 32 which is used as the buffer layer and the semiconductor layer 38 which is used as the anode layer are formed by the epitaxial growth method, the thickness of the epitaxial growth layer can be reduced and the manufacturing cost can be lowered in comparison with the conventional method in which the base layer is formed by the epitaxial growth method.

Further, like the embodiment of FIG. 11A, since the n-type semiconductor substrate is used as the base layer, a semiconductor device of high withstand voltage can be attained by forming a sufficiently thick base layer.

Further, in comparison with the conventional method in which the buffer layer and anode layer are both formed by the diffusion method, in this embodiment, since the base layer is formed to have desired concentration by the epitaxial growth method, the concentration distribution in the junction plane between the buffer layer and the anode layer can be made sharp. Therefore, like the embodiment shown in FIG. 11A, the injection efficiency of holes from the anode layer can be enhanced and the on-state voltage can be lowered. As described above, since the anode layer is formed by diffusing impurity into the semiconductor layer 36 or 38 formed with low concentration, the epitaxial growth layer can be selectively formed in the form of the n-type semiconductor layer 36 or the p-type semiconductor layer 38.

Generally, in order to prevent impurity of different conductivity type from being introduced into the epitaxial growth layer, different devices are used as a device for forming an n-type epitaxial growth layer and a device for forming a p-type epitaxial growth layer.

Therefore, in the method for forming the p-type semiconductor layer 31 on the n-type semiconductor layer 32 shown in FIG. 10C by use of the epitaxial growth method, it is necessary to take out the semiconductor device from the n-type epitaxial growth layer forming device after the n-type semiconductor layer 32 is formed by the epitaxial growth method and then process the semiconductor device in the p-type epitaxial growth layer forming device.

In this case, there occurs a possibility that contaminant is introduced into between the n-type semiconductor layer 32 and the p-type semiconductor layer 31. Further, it is necessary to additionally effect a process for eliminating the contaminant.

However, in a case where the n-type semiconductor layer 36 having the same conductivity type as the semiconductor layer 32 is formed on the n-type semiconductor layer 32 as shown in FIG. 11A, the semiconductor device can be easily formed by changing the concentration of impurity to be doped in the same epitaxial growth layer forming device.

Further, if the impurity concentration of the semiconductor layer 36 shown in FIG. 11A or the semiconductor layer 38 shown in FIG. 12A at the time of epitaxial growth is lower than 1 × 10¹⁵ cm⁻³, for example, the anode layer having desired impurity concentration can be easily formed by use of the diffusion method irrespective of the impurity concentration of the semiconductor layer.

In the embodiments shown in FIGS. 9B, 10C, 11C and 12C, the base layer can be formed with a desired thickness by polishing the rear surface of the semiconductor substrate 33 after the epitaxial growth layer is formed. Thus, a base layer with an optimum thickness capable of achieving a sufficiently high withstand voltage and lowering the ON resistance can be formed.

In each of the above embodiments, it is preferable to continuously effect the epitaxial growth process in the same device. As described before, it is common practice to use different epitaxial growth devices according to the conductivity types, but the possibility of contamination can be lowered and a processing step can be omitted by continuously forming semiconductor layers by changing the concentration of impurity to be doped in the same device. Thus, a semiconductor substrate of high quality which can be used to form a thyristor having a low on-state voltage and high withstand voltage can be attained at low cost.

TABLE 1 shows the result of comparison between the withstand voltages and on-state voltages of thyristors which are respectively formed by using a semiconductor substrate formed by use of the conventional epitaxial growth method, a semiconductor substrate formed by use of the conventional diffusion method and a semiconductor substrate formed by use of the manufacturing method of this invention.

**TABLE 1**

| | withstand voltage of 200V | injection efficiency (on-state voltage) | cost |
|---|---|---|---|
| conventional semiconductor substrate | X | ○ (2V) | X |
| conventional semiconductor substrate | ○ | X (3.5V) | ○ |
| semiconductor substrate of this invention | ○ | ○ (2V) | △ |

As described in TABLE 1, the thyristor formed by use of the semiconductor substrate which is formed by the manufacturing method of this invention has a withstand voltage of 2000V or more and can attain an on-state voltage of 2V. Thus, enhancement of the withstand voltage and lowering of the on-state voltage which cannot be simultaneously attained by the conventional manufacturing method can be simultaneously attained by the manufacturing method of this invention.

## Claims

1. A semiconductor device characterized by comprising:
an n-type semiconductor substrate (33) used as a base;
a p-type region (4) formed on one surface of said n-type semiconductor substrate;
an n-type region (5) formed in said p-type region and used as a cathode layer; and
a p-type epitaxial growth layer (31) formed on the opposite surface of said n-type semiconductor substrate and used as an anode layer.

2. A semiconductor device characterized by comprising:
an n-type semiconductor substrate (33) used as a base;
a p-type region (4) formed on one surface of said n-type semiconductor substrate;
an n-type region (5) formed in said p-type region and used as a cathode layer;
a first epitaxial growth layer (32) of n type with high impurity concentration formed on the opposite surface of said n-type semiconductor substrate; and
a second epitaxial growth layer (31) of p type formed on said first epitaxial growth layer of n type and used as an anode layer.

3. A method for manufacturing a semiconductor device, characterized by comprising the steps of:
forming a p-type region (4) on one surface of an n-type semiconductor substrate (33) used as a base;
forming an n-type region (5) used as a cathode layer in the p-type region; and
forming a p-type epitaxial growth layer (31) used as an anode layer on the opposite surface of the n-type semiconductor substrate.

4. A method for manufacturing a semiconductor device, characterized by comprising the steps of:
forming a first epitaxial growth layer (32) of n type on one surface of an n-type semiconductor substrate; and
forming a second epitaxial growth layer (31) of p type used as an anode layer on the first epitaxial growth layer.

5. A method for manufacturing a semiconductor device according to claim 4, characterized by further comprising a step of polishing the rear surface of the semiconductor substrate after the second epitaxial growth layer is formed.

6. A method for manufacturing a semiconductor device according to claim 4, characterized in that the first epitaxial growth layer is formed to make an n-type semiconductor layer in which the product of the thickness and the concentration is set in a range of 10¹⁴ cm⁻² to 10¹⁵ cm⁻².

7. A method for manufacturing a semiconductor device according to claim 5, characterized in that the first epitaxial growth layer is formed to make an n-type semiconductor layer in which the product of the thickness and the concentration is set in a range of 10¹⁴ cm⁻² to 10¹⁵ cm⁻².

8. A method for manufacturing a semiconductor device according to claim 4, characterized in that the second epitaxial growth layer is formed to make a semiconductor layer which contains p-type impurity with the concentration of not less than 10¹⁸ cm⁻³ and whose thickness is not less than 3 µm.

9. A method for manufacturing a semiconductor device according to claim 5, characterized in that the second epitaxial growth layer is formed to make a semiconductor layer which contains p-type impurity with the concentration of not less than 10¹⁸ cm⁻³ and whose thickness is not less than 3 µm.

10. A method for manufacturing a semiconductor device according to claim 6, characterized in that the second epitaxial growth layer is formed to make a semiconductor layer which contains p-type impurity with the concentration of not less than 10¹⁸ cm⁻³ and whose thickness is not less than 3 µm.

11. A method for manufacturing a semiconductor device according to claim 4, characterized in that the second epitaxial growth layer is first formed to make a semiconductor layer which contains impurity with the concentration of not more than 10¹⁵ cm⁻³ and whose thickness is not less than 3 µm, and then the second epitaxial growth layer is formed to have the surface concentration of p-type impurity of not less than 10¹⁸ cm⁻³ by doping p-type impurity from the surface thereof by use of the diffusion method.

12. A method for manufacturing a semiconductor device according to claim 5, characterized in that the second epitaxial growth layer is first formed to make a semiconductor layer which contains impurity with the concentration of not more than 10¹⁵ cm⁻³ and whose thickness is not less than 3 µm, and then the second epitaxial growth layer is formed to have the surface concentration of p-type impurity of not less than 10¹⁸ cm⁻³ by doping p-type impurity from the surface thereof by use of the diffusion method.

13. A method for manufacturing a semiconductor device according to claim 6, characterized in that the second epitaxial growth layer is first formed to make a semiconductor layer which contains impurity with the concentration of not more than 10¹⁵ cm⁻³ and whose thickness is not less than 3 µm, and then the second epitaxial growth layer is formed to have the surface concentration of p-type impurity of not less than 10¹⁸ cm⁻³ by doping p-type impurity from the surface thereof by use of the diffusion method.

14. A method for manufacturing a semiconductor device according to claim 7, characterized in that the second epitaxial growth layer is first formed to make a semiconductor layer which contains impurity with the concentration of not more than 10¹⁵ cm⁻³ and whose thickness is not less than 3 µm, and then the second epitaxial growth layer is formed to have the surface concentration of p-type impurity of not less than 10¹⁸ cm⁻³ by doping p-type impurity from the surface thereof by use of the diffusion method.
